# EUROPEAN PATENT SPECIFICATION

(11) **EP 1 076 667 B1**
(45) Date of publication and mention of the grant of the patent: **24.03.2004**
(21) Application number: 99911412.7
(22) Date of filing: 15.03.1999
(51) Int. Cl.: C08F 8/12, G03F 7/039

(54) **PREPARATION OF CO-AND TERPOLYMERS OF P-HYDROXYSTYRENE AND ALKYL ACRYLATES**
HERSTELLUNG VON CO- UND TERPOLYMEREN VON P-HYDROXYSTYROL UND ALKYLACRYLATEN
PREPARATION CONSTITUEE DE CO ET TERPOLYMERES DE P-HYDROXYSTYRENE ET D'ACRYLATES D'ALKYLE

(30) Priority: 05.05.1998 US 72936
(43) Date of publication of application: 21.02.2001
(73) Proprietor: TRIQUEST, L.P., Dallas, TX 75240 (US)
(72) Inventor: SHEEHAN, Michael, T., Corpus Christi, TX 78414 (US); SOUNIK, James, R., Corpus Christi, TX 78414 (US)
(74) Representative: James, Anthony Christopher W.P.
(86) International application number: PCT/US1999/005667
(87) International publication number: WO 1999/057163

(56) References cited:
- EP-A- 0 260 104
- EP-A- 0 277 721
- EP-A- 0 544 324
- EP-A- 0 605 089
- EP-A- 0 813 113
- WO-A-94/14858
- US-A- 4 636 540
- US-A- 4 689 371
- US-A- 4 877 843

## Description

### BACKGROUND OF THE INVENTION

### Field of the Invention

This invention relates to the selective hydrolysis of co- and ter-polymers of p-acetoxystyrene (ASM) and alkyl acrylates which are useful in photoresists and optical applications.

### Description of the Prior Art

There is a desire in the industry for higher circuit density in microelectronic devices which are made using lithographic techniques. One method of increasing the number of components per chip is to decrease the minimum feature size on the chip, which requires higher lithographic resolutions. The use of shorter wavelength radiation (e.g., deep UV e.g. 190 to 315 am) than the currently employed mid-UV spectral range (e.g. 350 am to 450 am) offers the potential for higher resolution. However, with deep UV radiation, fewer photons are transferred for the same energy dose and higher exposure doses are required to achieve the same desired photochemical response. Further, current lithographic tools have greatly attenuated output in the deep UV spectral region.

In order to improve sensitivity, several acid catalyzed chemically amplified resist compositions have been developed such as those disclosed in U.S. Pat. No. 4,491,628 (Jan. 1, 1985) and Nalamasu et al, "An Overview of Resist Processing for Deep UV Lithography", J. Photopolymer Sci. Technol. 4, 299 (1991). The resist compositions generally comprise a photosensitive acid generator and an acid sensitive polymer. The polymer has acid sensitive side chain (pendant) groups which are bonded to the polymer backbone and are reactive towards a proton. Upon imagewise exposure to radiation, the photoacid generator produces a proton. The resist film is heated and, the proton causes catalytic cleavage of the pendant group from the polymer backbone. The proton is not consumed in the cleavage reaction and catalyzes additional cleavage reactions thereby chemically amplifying the photochemical response of the resist. The cleaved polymer is soluble in polar developers such as alcohol and aqueous base while the unexposed polymer is soluble in nonpolar organic solvents such as anisole. Thus the resist can produce positive or negative images of the mask depending of the selection of the developer solvent.

Although chemically amplified resist compositions generally have suitable lithographic sensitivity, in certain applications, their performance can be improved by (i) increasing their thermal stability in terms of thermal decomposition and plastic flow and (ii) increasing their stability in the presence of airborne chemical contaminants. For example, in some semiconductor manufacturing processes, post image development temperatures (e.g. etching, implantation etc.) can reach 200°C. Brunsvold et al., U.S. Pat. Nos. 4,939,070 (issued Jul. 3, 1990) and 4,931,379 (issued Jun. 5, 1990) disclose chemically amplified, acid sensitive resist compositions having increased thermal stability in the post image development stage. Brunsvold's resist compositions form a hydrogen bonding network after cleavage of the acid sensitive side chain group to increase the thermal stability of the polymer. Brunsvold avoids hydrogen bonding moieties prior to the cleavage reaction because such hydrogen bonding is known to unacceptably destabilize the acid sensitive side chain. Although Brunsvold resists have suitable thermal stability, they also have lower sensitivity and therefore are unsuitable in certain applications.

With respect to chemical contamination, MacDonald et al. SPIE 14662. (1991) reported that due to the catalytic nature of the imaging mechanisms, chemically amplified resist systems are sensitive toward minute amounts of airborne chemical contaminants such as basic organic substances. These substances degrade the resulting developed image in the film and cause a loss of the linewidth control of the developed image. This problem is exaggerated in a manufacturing process where there is an extended and variable period of time between applying the film to the substrate and development of the image. In order to protect the resist from such airborne contaminants, the air surrounding the coated film is carefully filtered to remove such substances. Alternatively, the resist film is overcoated with a protective polymer layer. However. these are cumbersome processes.

Therefore, there was a need in the art for an acid sensitive, chemically amplified photoresist composition having high thermal stability and stability in the presence of airborne chemical contaminants for use in semiconductor manufacturing. Apparently, this was accomplished in the invention outlined in U.S. 5,625,020 which relates to a photosensitive resist composition comprising (i) a photosensitive acid generator and (ii) a polymer comprising hydroxystyrene and acrylate, methacrylate or a mixture of acrylate and methacrylate. The resist has high lithographic sensitivity and high thermal stability. The resist also exhibits surprising stability in the presence of airborne chemical contaminants. However, one of the problems with this composition was that the process of preparing the polymer as outlined in column 3, lines 10-30 and in Example 1 (of U.S. 5,625,020) results in poor conversion rates and chemical cleavage of some groups in the repeat units. Thus, one of the objects of the present invention is an improved process for preparing the polymers used in the photoresist compositions.

### Prior Art

The following references are disclosed as general background information.
1. U.S. 4,898,916 discloses a process for the preparation of poly(vinylphenol) from poly(acetoxystyrene by acid catalyzed transesterification.
2. U.S. 5,239,015 discloses a process for preparing low optical density polymers and co-polymers for photoresists and optical applications.
3. U.S. 5,625,007 discloses a process for making low optical polymers and co-polymers for photoresists and optical applications.
4. U.S. 5,625,020 discloses a process for making a photoresist composition containing a photosensitive acid generator and a polymer comprising the reaction product of hydroxystyrene with acrylate, methacrylate or a mixture of acrylate and methacrylate.

Other patents of interest are U.S. 4,679,843; U.S. 4,822,862; U.S. 4,912,173; and U.S. 4,962,147.

### SUMMARY OF THE INVENTION

This invention relates to a novel, one-pot, cost efficient process for the preparation of co- and terpolymers of p-hydroxystyrene and alkyl acrylates. The process involves polymerization of esters of p-hydroxystyrene, alkyl acrylate monomers and optionally one or more of ethylenically unsaturated monomers in an alcoholic solvent in the presence of a free radical initiator. Subsequent hydrolysis of so formed polymer under transesterification conditions using catalytic amounts of base catalyst results in co- and/or terpolymers of p-hydroxystyrene without cleavage of the alkyl ester in the acrylate repeat unit. Preferred embodiments include copolymers of p-hydroxystyrene and tert-butyl acrylate and terpolymer of p-hydroxystyrene, tert-butyl acrylate and styrene. These polymers have a wide variety of applications including as photoresists in microelectronics industry.

The present invention thus provides, in part, a novel process for producing polymers which are used in photoresist compositions. The process is an improvement over the prior art and is quite efficient. Specifically, this invention provides a process for the preparation of a polymer of IV, 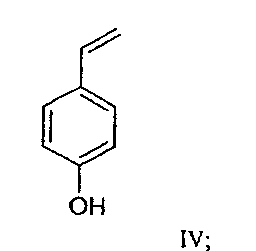 an acrylate monomer having the formula II, 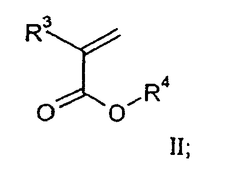 and optionally one or more ethylenically unsaturated copolymerizable monomers selected from the group consisting of styrene, 4-methylstyrene, maleic anhydride, dialkyl maleate, dialkyl fumarate and vinyl chloride, wherein alkyl is having 1 to 4 carbon atoms, comprising the steps of:
(a) subjecting a monomer of formula V, 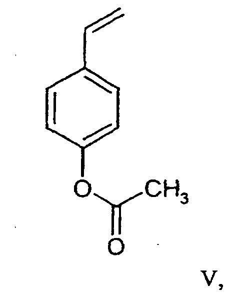 said monomer II, and optionally one or more of said copolymerizable monomers to suitable polymerization conditions in an alcoholic solvent and in the presence of a free radical initiator at suitable temperature for a sufficient period of time to produce a polymer of corresponding composition;
(b) subjecting said polymer from step (a) to transesterification conditions in said alcoholic solvent in the presence of catalytic amounts of an alkali metal alkoxide or alkali metal hydroxide base catalyst at suitable temperature such that the transesterified by-product ester formed is continuously removed from the reaction mixture to form the polymer of I, II, and optionally said copolymerizable monomer;
(c) passing said polymer solution in said alcoholic solvent from step (b) through an acidic ion-exchange bed to remove said base catalyst; and
(d) isolating said polymer from step (c) by precipitation from said alcoholic solvent;
   wherein:
   (i) R³ is hydrogen or methyl; and
   (ii) R⁴ is either iso-propyl or ter-butyl.

### DETAILED DESCRIPTION OF THE INVENTION

In a preferred embodiment the reaction mixture may also comprise an additional co-solvent. The co-solvent is selected from the group consisting of tetrahydrofuran, methyl ethyl ketone, acetone, and 1,4-dioxane.

The alcoholic solvent is an alcohol having 1 to 4 carbon atoms and is selected from the group consisting of methanol, ethanol, isopropanol, tert-butanol, and combinations thereof. The amount of solvent (or co-solvent) used is not critical and can be any amount which accomplishes the desired end result.

The free radical initiator may be any initiator which achieves the desired end result. The initiator may be selected from the group consisting of 2,2'-azobis(2,4-dimethylpentanenitrile), 2,2'-azobis(2-methylpropanenitrile), 2,2'-azobis(2-methylbutanenitrile), 1,1'-azobis(cyclohexanecarbonitrile), t-butyl peroxy-2-ethylhexanoate, t-butyl peroxypivalate, t-amyl peroxypivalate, diisononanoyl peroxide, decanoyl peroxide, succinic acid peroxide, di(n-propyl) peroxydicarbonate, di(sec-butyl) peroxydicarbonate, di(2-ethylhexyl) peroxydicarbonate, t-butylperoxyneodecanoate, 2,5-dimethyl-2,5-di(2-ethylhexanoylperoxy)hexane, t-amylperoxyneodecanoate, and combinations thereo f.

As a preferred embodiment, the initiator is selected from the group consisting of 2,2'-azobis(2,4-dimethylpentanenitrile), 2,2'-azobis(2-methylpropanenitrile), 2,2'-azobis(2-methylbutanenitrile), 1,1'-azobis(cyclohexanecarbonitrile), t-butyl peroxy-2-ethylhexanoate, t-butyl peroxypivalate, t-amyl peroxypivalate, and combinations thereof.

The amount of initiator is any amount which accomplishes the desired end result. However, as a preferred embodiment, said initiator is present to about three mole percent based upon the total moles of all of said monomers I, II, and said copolymerizable monomers.

The polymerization conditions are not critical and can be any temperature and pressure which will produce the desired end result. In general, the temperatures are from about 30°C to about 100°C, preferably from about 40°C to about 100°C, and most preferably from about 45°C to about 90°C. The pressure may be atmospheric, sub-atmospheric or super-atmospheric. The polymerization time is not critical, but generally will take place over a period of at least one minute in order to produce a polymer of corresponding composition.

In step (b), in a transesterification, the polymer step (a) is subjected to said transesterification conditions in said alcoholic solvent in the presence of catalytic amounts of a base catalyst. The base catalyst is such that it will not substantially react with said alkyl acrylate monomer II, or with said co-polymerizable monomers. The base catalyst is either an alkalic metal hydroxide or an alkalic metal alkoxide. The base catalyst is selected from the group consisting of lithium hydroxide. lithium methoxide, lithium ethoxide, lithium isopropoxide, sodium hydroxide, sodium methoxide, sodium ethoxide, sodium isopropoxide, potassium hydroxide, potassium methoxide, potassium ethoxide. potassium isopropoxide, cesium hydroxide, cesium methoxide, cesium ethoxide, cesium isopropoxide, and combinations thereof.

The amount of base catalyst employed is from about 0.1 mole percent to about 2 mole percent based upon the atomic weight of the metal (e.g. sodium) and the moles of monomer 1 present in said polymer.

In a preferred embodiment, the base catalyst is added in step (b) by dissolving it in said alcoholic solvent.

The temperature in step (b) is such that the transesterified by-product ester formed can be continually removed from the reaction mixture to form the polymer of I, II, and said copolymerizable monomer. Such temperatures can be from about 50°C to about 200°C. The transesterification reaction is carried out at reflux temperature of said alcoholic solvent.

In step (c), the ion exchange bed is an acidic ion exchange resin, preferably a strongly acidic cation exchange resin. An acidic ion exchange resin, such as sulfonated styrene/divinylbenzene cation exchange resin is utilized in the present process. Suitable acidic exchange resins are available from Rohm and Haas Company, e.g. AMBERLYST 15 acidic ion exchange resin. These amberlyst resins typically contain as much as 80,000 to 200,000 ppb of sodium and iron. Before being utilized in the process of the invention, the ion exchange resin must be treated with water and then a mineral acid solution (acidic resin) to reduce the metal ion level. When purifying the polymer solution, it is important that the ion exchange resin is then rinsed with a solvent which is the same as, or at least compatible with, the polymer solution solvent. The procedure in step (c) may be similar to those procedures disclosed in U.S. 5,284,930 and U.S. 5,288,850.

In step (d), the isolation may be accomplished by precipitation of said polymer from said reaction medium by adding said reaction medium to a non-solvent is selected from the group consisting of water, hexane, octane, petroleum ether, and combinations thereof.

As an example of the preparation of the terpolymer described above, there is provided a process for the preparation of a polymer of IV, 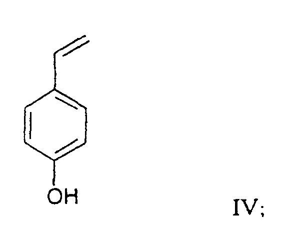 an alkyl acrylate monomer having the formula II, 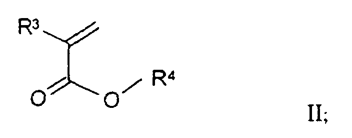 and an ethylenically unsaturated copolymerizable monomer selected from the group consisting of styrene, 4-methylstyrene, maleic anhydride, dialkyl maleate, dialkyl fumarate and vinyl chloride, wherein alkyl is having 1 to 4 carbon atoms, comprising the steps of:
a) subjecting a monomer of formula V, 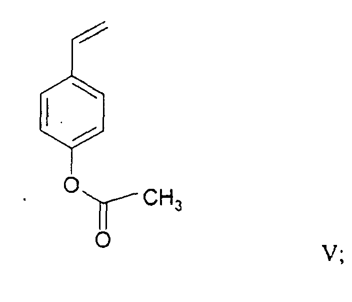 along with said monomer II, and said copolymerizable monomer to suitable polymerization conditions in an alcoholic solvent and in the presence of a free radical initiator at suitable temperature for a sufficient period of time to produce a polymer of corresponding composition;
b) subjecting said polymer from step a) to transesterification conditions in said alcoholic solvent in the presence of catalytic amounts of a base catalyst at reflux temperature of said alcoholic solvent such that the transesterified by-product acetate formed is continuously removed from the reaction mixture to form the polymer of IV, II, and said copolymerizable monomer;
c) passing said polymer solution in said alcoholic solvent from step b) through an ion-exchange bed to remove said base catalyst; and
d) isolating said polymer from step c) by precipitation from said alcoholic solvent;
   wherein:
   i) R³ is either hydrogen or methyl; and
   ii) R⁴ is either isopropyl or tert-butyl.

The initiator is selected from the group consisting of 2,2'-azobis(2,4-dimethylpentanenitrile), 2,2'-azobis(2-methylpropanenitrile), 2,2'-azobis(2-methylbutanenitrile), 1,1'-azobis(cyclohexanecarbonitrile), t-butyl peroxy-2-ethylhexanoate, t-butyl peroxypivalate, t-amyl peroxypivalate, and combinations thereof. The alcoholic solvent is an alcohol having 1 to 4 carbon atoms selected from the group consisting of methanol, ethanol, isopropanol, tert-butanol, and combinations thereof. A preferred embodiment is where the alcoholic solvent is methanol. The base catalyst will not substantially react with said alkyl acrylate monomer II or with said copolymerizable monomers and is either alkali metal hydroxide or alkali metal alkoxide, and further is selected from the group consisting of lithium hydroxide, lithium methoxide, lithium ethoxide, lithium isopropoxide, sodium hydroxide, sodium methoxide. sodium ethoxide, sodium isopropoxide, potassium hydroxide, potassium methoxide, potassium ethoxide, potassium isopropoxide, cesium hydroxide, cesium methoxide, cesium ethoxide, cesium isopropoxide, and combinations thereof. As a preferred embodiment, the base catalyst is sodium methoxide and is present in an amount of about 0.1 mole percent to about 2 mole percent based upon the atomic weight of sodium and moles of monomer IV present in said polymer. Furthermore, the said base catalyst is added in step b) by dissolving it in said alcoholic solvent, and the precipitation of said polymer is accomplished by adding said reaction medium to a non-solvent which is selected from the group consisting of water, hexane, octane, petroleum ether, and combinations thereof. The preferred non-solvent is water. Thus in this example of the novel process, said polymer is a terpolymer of monomer IV, monomer II, and styrene.

In another facet of the present invention there is provided a process for the reparation of a copolymer of IV, 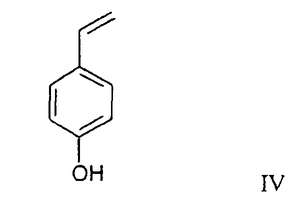 and an alkyl acrylate monomer having the formula II, 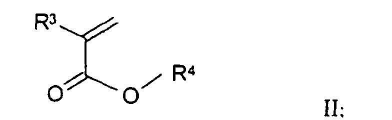 comprising the steps of:
a) subjecting monomer of formula V, 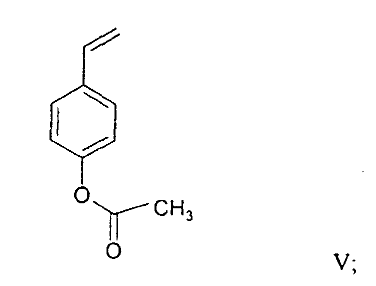 and said monomer II to suitable polymerization conditions in an alcoholic solvent and in the presence of a free radical initiator at suitable temperature for a sufficient period of time to produce a polymer of corresponding composition;
b) subjecting said polymer from step a) to transesterification conditions in said alcoholic solvent in the presence of catalytic amounts of a base catalyst at reflux temperature of said alcoholic solvent such that the transesterified by-product acetate formed is continuously removed from the reaction mixture to form the polymer of IV and II;
c) passing said polymer solution in said alcoholic solvent from step b) through an ion-exchange bed to remove said base catalyst; and
d) isolating said polymer from step c) by precipitation from said alcoholic solvent;
   wherein:
   i) R³ is either hydrogen or methyl; and
   ii) R⁴ is either isopropyl or tert-butyl.

In this process for the preparation of a copolymer, the initiator is selected from the group consisting of 2,2'-azobis(2,4-dimethylpentanenitrile), 2,2'-azobis(2-methylpropanenitrile), 2,2'-azobis(2-methylbutanenitrile), 1,1'-azobis(cyclohexanecarbonitrile), t-butyl peroxy-2-ethylhexanoate, t-butyl peroxypivalate, t-amyl peroxypivalate, and combinations thereof. The alcoholic solvent is an alcohol having 1 to 4 carbon atoms selected from the group consisting of methanol, ethanol, isopropanol, tert-butanol, and combinations thereof. The base catalyst will not substantially react with said alkyl acrylate monomer II and is either alkali metal hydroxide or alkali metal alkoxide, selected from the group consisting of lithium hydroxide, lithium methoxide, lithium ethoxide, lithium isopropoxide, sodium hydroxide, sodium methoxide, sodium ethoxide, sodium isopropoxide, potassium hydroxide, potassium methoxide, potassium ethoxide, potassium isopropoxide, cesium hydroxide, cesium methoxide, cesium ethoxide, cesium isopropoxide, and combinations thereof. The base catalyst, e.g., can be sodium methoxide and is present in an amount of about 0.1 mole percent to about 2 mole percent based upon the atomic weight of the metal (e.g. sodium) and moles of monomer IV present in said polymer.

This invention is further illustrated by the following examples.

### Examples (General)

In the Examples that follow, the following abbreviations are used:
ASM - p-Acetoxystyrene monomer
t-BPP - tert-butyl peroxypivalate
THF - Tetrahydrofuran
GPC - Gel permeation chromatography
GC - Gas chromatography
FTIR - Fourier transform infrared spectroscopy
NMR - Nuclear magnetic resonance spectroscopy, usually of either proton, ¹H;
and/or carbon 13, ¹³C nuclei.
DSC - Differential scanning calorimetry
UV-Vis - Ultraviolet-Visible Spectroscopy

General Analytical Techniques Used for the Characterization: A variety of analytical techniques were used to characterize the co- and terpolymers of the present invention which included the following:
NMR: ¹H and ¹³C NMR spectra were recorded on a Bruker 400 MHz spectrometer with 5 mm probes at 400 and 100 MHz, respectively.
GPC: GPC was performed on a Waters gel permeation chromatograph equipped with refractive index detection.
GC: GC analysis was performed on a Hewlett Packard Model 5890 series II gas chromatograph equipped with a DB-1 column.
FTIR: FTIR was recorded on a Mattson Genesis Series FTIR.
DSC: A Perkin Elmer 7700 DSC.was used to determine the T_{g} (glass transition temperature) of the co- and terpolymers of this invention. The heating rate was maintained at 10°C/minute, generally, over a temperature range of 50°C to 400°C.
The flow rate of nitrogen or air is maintained at 20 mL/min.
UV-V is of samples were taken using a Hewlett Packard Vectra 486/33VL UV-Vis spectrophotometer

### Example 1 (a Comparative Example)

A four-neck 500 mL glass round-bottom flask fitted with a chilled water reflux condenser, a thermowell with thermocouple, a nitrogen inlet and outlet, an overhead stirrer, and an external heating mantle was charged with a reaction mixture of 73.1 grams (0.44 moles) of ASM, 15.9 grams (0.15 moles) of styrene, and 13.4 grams (0.10 moles) of t-butyl acrylate with stirring. To this mixture was then added 117 grams of methanol and the entire reaction mixture was heated to 66°C over a period of one hour. At this time the polymerization was initiated by adding 11 grams (75% concentration; 7 mole percent based upon total number of moles of monomers) of t-BPP diluted in 11 grams of methanol. After one hour of polymerization, 0.66 grams of t-BPP diluted in 1 gram of methanol was added. At each hour, for the next 3 hours, 0.66 grams of t-BPP in 1 gram of methanol was added. After each addition, a sample of the polymer mixture was withdrawn from the reactor and analyzed for the unreacted monomers by capillary gas chromatography (GC). The polymerization reaction was continued for about a total period of 18 hours. At the end of this period, analysis of the final polymer mixture sample by capillary GC showed greater than 98% by weight conversion of the monomers to polymer. The transesterification reaction of p-acetoxy groups to p-hydroxy groups was begun without cooling the reaction mixture: 0.9 grams of sodium methoxide dissolved in 4 grams of methanol was added to the reaction mixture (of this 0.4 grams of sodium methoxide was used to neutralize the acetic acid present in the ASM monomer and 0.5 grams to carry out the transesterification thus amounting to 2 mole percent of catalyst level). The reaction mixture was continued to reflux with concomitant removal of methanol/methyl acetate as distillate and fresh methanol was added to compensate for the distillate. The reaction mixture was allowed to react until the solution turned clear in about 4 hours at which time the reaction mixture was cooled, precipitated in deionized water, and the precipitated polymer was isolated by filtration. A ¹³C NMR analysis of the product indicated 86% conversion of the acetoxy groups to hydroxy groups. A ¹H NMR analysis indicated that the t-butyl groups in the acrylate repeat units were intact and were not cleaved during the transesterification reaction.

### Example 2 (a Comparative Example)

Example 1 was repeated in this Example 2 except that the transesterification reaction with sodium methoxide at 2 mole percent level was carried out for a period of about 18 hours under reflux. The by-product methyl acetate was continuously removed and requisite amounts of fresh methanol was added to compensate for methanol/methyl acetate distilled as in Example 1. Analysis of the final polymer product by ¹³C NMR indicated quantitative conversion of p-acetoxy groups to p-hydroxy groups and t-butyl groups of the acrylate repeat units were not cleaved as confirmed by ¹H NMR analysis.

### Example 3 (a Comparative Example)

Example 1 was repeated in this Example 3 with the exception that the amount of sodium methoxide used in the transesterification step was 0.43 grams as 25 weight percent solution in methanol. Ofthis amount 0.38 grams of sodium methoxide was used to neutralize acetic acid present in the ASM monomer. The remainder, 0.05 grams of sodium methoxide was used as the catalyst for transesterification, which amounted to 0.2 mole percent catalyst level. The transesterification reaction was carried out for a period of about of 52 hours under reflux. The solution was cloudy and the polymer precipitated when fresh methanol was added indicating that the transasacrification reaction was very slow at this catalyst level.

### Example 4

Example 1 was repeated in this Example 4 with the exception that 1.4 grams of sodium meihoxide was employed in the transesterification step, which amounted to four mole percent catalyst level after accounting for 0.38 grams of sodium methoxide needed to neutralize the acetic acid present in ASM. In addition, 15 grams of THF was charged into the reaction mixture in the transesterification step in order to improve the solubility of the polymer in methanol. After five and a half hours of refluxing in methanol, the polymer solution was completely clear at which time the reaction mixture was cooled. A portion of the polymer solution was precipitated in water and analyzed by NMR, which indicated quantitative conversion of p-acetoxy groups to p-hydroxy groups and the t-butyl groups were not cleaved. The remainder portion of the polymer solution was passed through an Amberlyst 15 ion exchange bed (2 inch (50.8 mm) diameter x 6 (152.4 mm) inch long), precipitated in deionized water, filtered and washed with deionized water. The white polymeric product was dried under vacuum at 65°C. The GPC analysis of the polymer showed weight-average molecular weight to be 9.700 and polydispersity of 2.1. The monomer composition of the polymer as determined by NMR was as follows: 61 mole% p-hydroxystyrene; 25 mole percent styrene; and 14 mole percent t-butyl acrylate.

### Example 5

Example 1 was repeated in Example 5 except that the reaction was carried out in a 5 liter round-bottom flask reactor employing following amounts of materials:

| | |
|---|---|
| ASM | 819.2 grams (96. 8 % purity; 4.9 moles) |
| Styrene | 177.9 grams (1.7 moles) |
| t-Butyl Acrylate | 150.1 grams (1.2 moles) |
| Methanol | 1342 grams |
| t-BPP | 116.2 grams (75.6 %; 6.5 mole % based upon total number of moles of monomers) |

After the polymerization was initiated, four additional batches of 7.4 grams of t-BPP was added to the reactor at the end of each hour and the polymerization reaction was continued for an additional period of about 18 hours. At the end of this period, 20 grams of sodium methoxide dissolved in 84 grams of methanol was added to the reactor. Of this amount, 4.2 grams of sodium methoxide was needed to neutralize the acetic acid and 15.8 grams (six mole % catalyst level) of sodium methoxide was used for transesterification. In the first hour, 162 grams of methanol/methyl acetate was distilled and 160 grams of fresh methanol and 150 grams THF was added to the reactor. In the next six hours, about 180 grams of methanol/methyl acetate was collected as distillate and the reactor was replaced with 180 grams of fresh methanol. Samples were taken every hour to determine the extent of transesterification reaction by NMR. At the end of six hours, the NMR analysis showed quantitative conversion of acetoxy groups to hydroxy groups at which time the reaction was stopped, and the reaction mixture was cooled to ambient temperature. The cooled polymer solution was pumped through an Amberlyst 15 ion exchange bed at a rate of 200 mL/minute. The ion exchange bed was then washed using an additional 2800 grams of fresh methanol to remove any adsorbed polymer on the bed. The polymer solution and the washings were then added dropwise into deionized water to precipitate the terpolymer. The polymer was filtered and dried under vacuum at 65°C. The GPC analysis of the polymer showed a weight-average molecular weight of 10,400 and polydispersity of 2. The polymer composition as determined by NMR analysis is as follows: 71 mole% p-hydroxystyrene; 19 mole percent styrene: and 10 mole percent t-butyl acrylate.

### Example 6

Example 1 was repeated in Example 6 except that the reaction was carried out in a 5 liter round-bottom flask reactor employing following amounts of materials:

| | |
|---|---|
| ASM | 811.9 grams (96.8 % purity; 4.8 moles) |
| Styrene | 176.3 grams (1.7 moles) |
| t-Butyl Acrylate | 148.8 grams (1.2 moles) |
| Methanol | 1330 grams |
| t-BPP | 115.2 grams (75.6 %; 6.5 mole % based upon total number of moles of monomers) |

After the polymerization was initiated, four additional batches of 7.4 grams of t-BPP was added to the reactor at the end of each hour and the polymerization reaction was continued for an additional period of about 18 hours. At the end of this period, 20 grams of sodium methoxide dissolved in 84 grams of methanol was added to the reactor. Of this amount, 4.2 grams of sodium methoxide was needed to neutralize the acetic acid and 15.8 grams (six mole % catalyst level) of sodium methoxide was used for transesterification. The transesterification reaction was carried out for a total period of 4 1/2 hours during which time about 900 grams of methanol/methyl acetate was collected as distillate and the reactor was replaced with 900 grams of fresh methanol. Samples were taken every hour to determine the extent of transesterification reaction by NMR. At the end of 4 1/2 hours, the NMR analysis showed quantitative conversion of acetoxy groups to hydroxy groups at which time the reaction was stopped. and the reaction mixture was cooled to ambient temperature. The cooled polymer solution was pumped through an Amberlyst 15 ion exchange bed at a rate of 200 mL/minute. The ion exchange bed was then washed using an additional 2800 grams of fresh methanol to remove any adsorbed polymer on the bed. The polymer solution and the washings were then added dropwise into deionized water to precipitate the terpolymer. The polymer was filtered and dried under vacuum at 65°C. The GPC analysis of the polymer showed a weight-average molecular weight of 10,400 and polydispersity of 2. The polymer was also analyzed for trace metals: aluminum 180 parts per billion(ppb); calcium 63 ppb; iron 120 ppb; sodium 270 ppb; zinc 21 ppb. The polymer composition as determined by NMR analysis is as follows: 62 mole percent p-hydroxystyrene; 24 mole percent styrene; and 15 mole percent t-butyl acrylate.

### Example 7

Example 1 was repeated in Example 7 except that the reaction was carried out in a 5 liter round-bottom flask reactor employing following amounts of materials:

| | |
|---|---|
| ASM | 700 grams (96.8% purity; 4.2 moles) |
| t-Butyl Acrylate | 334.6 grams (98% purity; 2.6 moles) |
| Methanol | 1200 grams |
| t-BPP | 72.9 grams (75.6%; 4.7 mole % based upon total number of moles of monomers) |

After the polymerization was initiated, four additional batches of 6.7 grams of t-BPP was added to the reactor at the end of each hour and the polymerization reaction was continued for an additional period of about 18 hours. At the end of this period, 16 grams of sodium methoxide dissolved in 64 grams of methanol was added to the reactor. Of this amount, 2.7 grams of sodium methoxide was needed to neutralize the acetic acid and 13.3 grams (six mole % catalyst level) of sodium methoxide was used for transesterification. The transesterification reaction was carried out for a total period of 4 hours by adding initially about 970 grams of methanol to the reaction mixture. Additional quantities of fresh methanol was added to the reaction mixture as methanol/methyl acetate was collected as distillate. Samples were taken every hour to determine the extent of transesterification reaction by NMR. At the end of 4 hours, the NMR analysis showed quantitative conversion of acetoxy groups to hydroxy groups at which time the reaction was stopped, and the reaction mixture was cooled to ambient temperature. The cooled polymer solution was pumped through an Amberlyst 15 ion exchange bed at a rate of 150 mL/minute. 300 mL of cooled polymer solution was added dropwise into 3000 mL of deionized water to precipitate the polymer. The polymer was filtered and dried under vacuum at 65°C; final dried product 700 grams. The GPC analysis of the polymer showed a weight-average molecular weight of 19,800 and polydispersity of 2.1. The polymer composition as determined by NMR analysis is as follows: 62 mole percent p-hydroxystyrene; and 38 mole percent t-butyl acrylate. A UV-VIS scan showed a molar absorptivity of 82 L cm⁻¹ mole⁻¹ at 248 nm. The polymer exhibited a T_{g} of 138.6°C as measured by DSC.

### Example 8

Example 1 was repeated in Example 8 except that the reaction was carried out in a 5 liter round-bottom flask reactor employing following amounts of materials:

| | |
|---|---|
| ASM | 700 grams (96.8% purity; 4.2 moles) |
| t-Butyl Acrylate | 334.6 grams (98% purity; 2.6 moles) |
| Methanol | 1200 grams |
| t-BPP | 72.9 grams (75.6%; 4.7 mole % based upon total number of moles of monomers) |

After the polymerization was initiated, four additional batches of 6.7 grams of t-BPP was added to the reactor at the end of each hour and the polymerization reaction was continued for an additional period of about 18 hours. At the end of this period, 16 grams of sodium methoxide dissolved in 64 grams of methanol was added to the reactor. Of this amount, 2.7 grams of sodium methoxide was needed to neutralize the acetic acid and 13.3 grams (six mole % catalyst level) of sodium methoxide was used for transesterification. The transesterification reaction was carried out for a total period of 4 1/2 hours by adding initially about 960 grams of methanol to the reaction mixture. Additional quantities of fresh methanol were added to the reaction mixture as methanol/methyl acetate was collected as distillate. Samples were taken every hour to determine the extent of transesterification reaction by NMR. At the end of 4 1/2 hours, the NMR analysis showed quantitative conversion of acetoxy groups to hydroxy groups at which time the reaction was stopped, and the reaction mixture was cooled to ambient temperature. The cooled polymer solution was pumped through two Amberlyst 15 ion exchange beds at a rate of 130 mL/minute. 300 mL of cooled polymer solution was added dropwise into 3000 mL of deionized water to precipitate the polymer. The precipitated polymer was filtered and dried under vacuum at 65°C. The GPC analysis of the polymer showed a weight-average molecular weight of 19,000 and polydispersity of 2. The polymer composition as determined by NMR analysis is as follows: 61 mole percent p-hydroxystyrene; and 39 mole percent t-butyl acrylate. A UV-VIS scan showed a molar absorptivity of 84 L cm⁻¹ mole⁻¹ at 248 nm. The polymer exhibited a T_{g} of 139.9°C as measured by DSC. Trace metal analysis showed the presence of following metals at the indicated levels: aluminum 69 ppb; calcium 57 ppb; iron 140 ppb; sodium 140 ppb; zinc 24 ppb.

### Example 9

Example 1 was repeated in Example 9 except that the reaction was carried out in a 5 liter round-bottom flask reactor employing following amounts of materials:

| | |
|---|---|
| ASM | 700 grams (96.8% purity; 4.2 moles) |
| t-Butyl Acrylate | 294 grams (98% purity; 2.25 moles) |
| Methanol | 1150 grams |
| t-BPP | 65.1 grams (75.6%; 4.7 mole % based upon total number of moles of monomers) |

After the polymerization was initiated, four additional batches of 6.4 grams of t-BPP was added to the reactor at the end of each hour and the polymerization reaction was continued for an additional period of about 18 hours. At the end of this period, 11.6 grams of sodium methoxide dissolved in 46 grams of methanol was added to the reactor. Of this amount, 2.6 grams of sodium methoxide was needed to neutralize the acetic acid and 9 grams (4 mole % catalyst level) of sodium methoxide was used for transesterification. The transesterification reaction was carried out for a total period of 8 1/2 hours by adding initially about 380 grams of methanol to the reaction mixture. Additional quantities of fresh methanol were added to the reaction mixture as methanol/methyl acetate was collected as distillate. Samples were taken every hour to determine the extent of transesterification reaction by NMR. At the end of 8 1/2 hours, the NMR analysis showed quantitative conversion of acetoxy groups to hydroxy groups at which time the reaction was stopped, and the reaction mixture was cooled to ambient temperature. The cooled polymer solution was pumped through an Amberlyst 15 ion exchange bed at a rate of 130 mL/minute. The cooled polymer solution was added dropwise into 3000 mL of deionized water to precipitate the polymer. The precipitated polymer was filtered and dried under vacuum at 65°C; yield 630 grams. The GPC analysis of the polymer showed a weight-average molecular weight of 18,000 and polydispersity of 2.3 The polymer composition as determined by NMR analysis is as follows: 66 mole percent p-hydroxystyrene; and 34 mole percent t-butyl acrylate. A UV-VIS scan showed a molar absorptivity of 86 L cm⁻¹ mole⁻¹ at 248 nm. The polymer exhibited a T_{g} of 149.1°C as measured by DSC.

### Example 10

Example 1 was repeated with the exception that sodium hydroxide was used as the catalyst. 0.07 grams of sodium hydroxide was used to neutralize the acetic acid present in ASM. 0.1 grams of sodium hydroxide was used as transesterification catalyst, which amounted to a catalyst level of 0.5 mole %. The transesterification reaction was carried out for a period of 4 hours under reflux in methanol while distilling-off methyl acetate/methanol and fresh methanol added to the reaction mixture as needed. At the end of this period, NMR analysis of the product indicated 70 percent of the acetoxy groups to hydroxy groups.

### Example 11

### Comparative Example

This Example demonstrate that large excess of triethylamine is needed to hydrolyze acetoxy groups to hydroxy groups. Example 1 was substantially repeated in Example 11 with the exception that triethylamine was used as the catalyst instead of sodium methoxide. 0.18 grams of triethylamine was used to neutralize the acetic acid in ASM and 0.48 grams of triethylamine was used for the transesterification reaction, which amounted to a catalyst level of 1 mole %. The reaction mixture was refluxed for 7 hours while removing continuously methanol/methyl acetate as distillate. The reaction was very slow and the polymer solution did not become clear during this time. Addition of fresh methanol resulted in precipitation of the unhydrolyzed polymer. At this time 27.9 grams of triethylamine (60 mole % catalyst level) was added to the reaction mixture and the reaction mixture was allowed to reflux for overnight (18 hours). Analysis of sample by NMR after this time indicated quantitative conversion of acetoxy groups to hydroxy groups. The reaction mixture was cooled and added dropwise to 3500 mL deionized water to precipitate the polymer. To completely remove triethylamine and the by-product, the filtered polymer was again taken in a 4 L beaker and filled with deionized water and heated to 50°C with stirring for 1 hour. The hot slurry was filtered. washed thoroughly with deionized water, and dried under vacuum at 65°C. The NMR analysis of the dried polymer showed no acetoxy groups.

### Example 12

### Comparative Example

This Example demonstrate that 4-dimethylaminopyridine (4-DMAP) is not effective a catalyst for transesterification. Example 1 was substantially repeated in Example 12 with the exception that 4-DMAP was used as the catalyst instead of sodium methoxide. 0.09 grams (0.15 mole %) of 4-DMAP in three equal portions was charged into the reaction mixture as the transesterification catalyst over a period of 5 hours and the reaction was continued for 18 hours during which time no appreciable amounts of transesterification took place as evidenced by the insolubility of the polymer in methanol. 0.6 grams (1 mole %) of additional 4-DMAP in five portions was added to the reaction mixture over a period of 7.1/2 hours and the reaction mixture was continued to reflux during this period. The reaction was still very slow and the polymer solution did not become clear during this time. Analysis of sample by NMR after this time indicated only 69 percent conversion of acetoxy groups to hydroxy groups.

## Claims

1. A process for the preparation of a copolymer of a monomer having the formula IV, 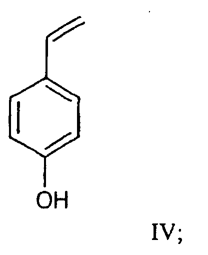 an alkyl acrylate monomer having the formula II, 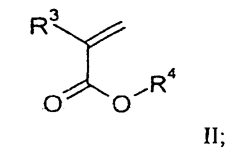 and optionally an ethylenically unsaturated copolymerizable monomer selected from the group consisting of styrene, 4-methylstyrene, maleic anhydride, dialkyl maleate, dialkyl fumarate and vinyl chloride, wherein alkyl is having 1 to 4 carbon atoms, comprising the steps of:
(a) subjecting a monomer of formula V, 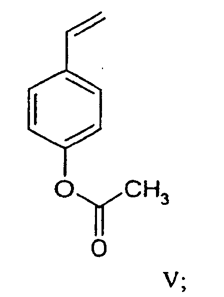 along with said monomer II, and optionally said copolymerizable monomer, to polymerization conditions in an alcoholic solvent and in the presence of a free radical initiator to produce a polymer of corresponding composition;
(b) subjecting said polymer from step (a) to transesterification conditions in said alcoholic solvent in the presence of catalytic amounts of an alkali metal alkoxide or alkali metal hydroxide base catalyst at reflux temperature of said alcoholic solvent such that the transesterified by-product acetate formed is continuously removed from the reaction mixture to form the polymer of IV, II and optionally said copolymerizable monomer;
(c) passing said polymer solution in said alcoholic solvent from step (b) through an acidic ion-exchange bed to remove said base catalyst; and
(d) isolating said polymer from step (c) by precipitation from said alcoholic solvent; wherein:
(i) R³ is either hydrogen or methyl; and
(ii) R⁴ is either isopropyl or tert-butyl.

2. The process as set forth in claim 1 wherein a monomer of the formula V, a monomer of the formula II and an ethylenically unsaturated copolymerisable monomer selected from styrene, 4-methylstyrene, maleic anhydride, dialkyl maleate, dialkyl fumarate and vinyl chloride, wherein each said alkyl has 1-4 carbon atoms, are subjected to polymerisation in step (a).

3. The process as set forth in claim 1 wherein the copolymer is a copolymer of 4-hydroxystyrene, a monomer of the formula II and optionally styrene.

4. The process as set forth in claim 1, 2 or 3 wherein R³ is hydrogen.

5. The process as set forth in claim 1, 2 or 3 wherein R³ is methyl.

6. The process as set forth in claim 1, 2 or 3, wherein the monomer of the formula II is tert-butyl acrylate.

7. The process as set forth in any of claims 1-6 wherein said initiator is selected from the group consisting of 2,2'-azobis(2,4-dimethylpentanenitrile), 2,2'-azobis(2-methylpropanenitrile), 2,2'-azobis(2-methylbutanenitrile), 1,1'-azobis(cyclohexanecarbonitrile), t-butyl peroxy-2-ethylhexanoate, t-butyl peroxypivalate, t-amyl peroxypivalate, and combinations thereof.

8. The process as set forth in any of claims 1-7 wherein said alcoholic solvent is an alcohol having 1 to 4 carbon atoms selected from the group consisting of methanol, ethanol, isopropanol, tert-butanol, and combinations thereof.

9. The process as set forth in claim 8 wherein said alcoholic solvent is methanol.

10. The process as set forth in any of claims 1-9 wherein said base catalyst is an alkali metal alkoxide.

11. The process as set forth in claim 10 wherein said base catalyst is selected from the group consisting of lithium methoxide, lithium ethoxide, lithium isopropoxide, sodium methoxide, sodium ethoxide, sodium isopropoxide, potassium methoxide, potassium ethoxide, potassium isopropoxide, cesium methoxide, cesium ethoxide, cesium isopropoxide, and combinations thereof.

12. The process as set forth in claim 11 wherein said base catalyst is sodium methoxide and is present in an amount of 0.1 mole percent to 2 mole percent based upon the atomic weight of sodium and moles of monomer IV present in said polymer.

13. The process as set forth in any of claims 1-12 wherein said base catalyst is added in step (b) by dissolving it in said alcoholic solvent.

14. The process as set forth in any of claims 1-13 wherein said precipitation of said polymer is accomplished by adding said reaction medium to a non-solvent.

15. The process as set forth in claim 14 wherein said non-solvent is selected from the group consisting of water, hexane, octane, petroleum ether, and combinations thereof.

16. The process as set forth in claim 15 wherein said non-solvent is water.

## Patentansprüche

1. Verfahren zur Herstellung eines Copolymers aus einem Monomer mit der Formel IV, 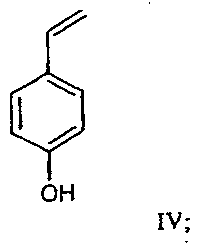 einem Alkylacrylatmonomer mit der Formel II, 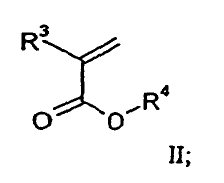 und gegebenenfalls einem ethylenisch ungesättigten, copolymerisierbaren Monomer, ausgewählt aus der Gruppe, bestehend aus Styrol, 4-Methylstyrol, Maleinsäureanhydrid, Dialkylmaleat, Dialkylfumarat und Vinylchlorid, wobei eine Alkylgruppe 1 bis 4 Kohlenstoffatome aufweist, umfassend die Schritte:
(a) Unterziehen eines Monomers der Formel V, 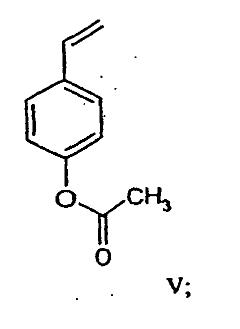 zusammen mit dem Monomer 11, und gegebenenfalls dem copolymerisierbaren Monomer, Polymerisationsbedingungen in einem alkoholischen Lösungsmittel und in Gegenwart eines Initiators vom freien Radikaltyp, um ein Polymer der entsprechenden Zusammensetzung herzustellen;
(b) Unterziehen des Polymers aus Schritt (a) Umesterungsbedingungen in dem alkoholischen Lösungsmittel in Gegenwart katalytischer Mengen eines basischen Alkalimetallalkoxid- oder Alkalimetallhydroxid-Katalysators bei Rückflußtemperatur des alkoholischen Lösungsmittels, so daß das umgeesterte gebildete Acetat-Nebenprodukt kontinuierlich von dem Reaktionsgemisch entfernt wird, um das Polymer aus IV, II und gegebenenfalls dem copolymerisierbaren Monomer zu bilden,
(c) Durchleiten der Polymerlösung in dem alkoholischen Lösungsmittel aus Schritt (b) durch ein saures Ionenaustauscherbett, um den basischen Katalysator zu entfernen, und
(d) Isolieren des Polymers aus Schritt (c) durch Ausfällen aus dem alkoholischen Lösungsmittel, wobei:
(i) R³ entweder Wasserstoff oder Methyl ist und
(ii) R⁴ entweder Isopropyl oder tert-Butyl ist.

2. Verfahren nach Anspruch 1, wobei ein Monomer der Formel V, ein Monomer der Formel II und ein ethylenisch ungesättigtes copolymerisierbares Monomer, ausgewählt aus Styrol, 4-Methylstyrol, Maleinsäureanhydrid, Dialkylmaleat, Dialkylfumarat und Vinylchlorid, wobei die Alkylgruppe jeweils 1 bis 4 Kohlenstoffatome aufweist, einer Polymerisation in Schritt (a) unterzogen werden.

3. Verfahren nach Anspruch 1, wobei das Copolymer ein Copolymer aus 4-Hydroxystyrol, einem Monomer der Formel II und gegebenenfalls Styrol ist.

4. Verfahren nach Anspruch 1, 2 oder 3, wobei R³ Wasserstoff ist.

5. Verfahren nach Anspruch 1, 2 oder 3, wobei R³ Methyl ist.

6. Verfahren nach Anspruch 1, 2 oder 3, wobei das Monomer der Formel II tert-Butylacrylat ist.

7. Verfahren nach einem der Ansprüche 1 bis 6, wobei der Initiator aus der Gruppe, bestehend aus 2,2'-Azobis(2,4-dimethylpentannitril), 2,2'-Azobis(2-methylpropannitril), 2,2'-Azobis(2-Methylbutannitril), 1,1 '-Azobis(cyclohexancarbonitril), t-Butylperoxy-2-ethylhexanoat, t-Butylperoxypivalat, t-Amylperoxypivalat und Kombinationen davon, ausgewählt ist.

8. Verfahren nach einem der Ansprüche 1 bis 7, wobei das alkoholische Lösungsmittel ein Alkohol mit 1 bis 4 Kohlenstoffatomen, ausgewählt aus der Gruppe, bestehend aus Methanol, Ethanol, Isopropanol, tert-Butanol und Kombinationen davon, ist.

9. Verfahren nach Anspruch 8, wobei das alkoholische Lösungsmittel Methanol ist.

10. Verfahren nach einem der Ansprüche 1 bis 9, wobei der basische Katalysator ein Alkalimetallalkoxid ist.

11. Verfahren nach Anspruch 10, wobei der basische Katalysator aus der Gruppe, bestehend aus Lithiummethoxid, Lithiumethoxid, Lithiumisopropoxid, Natriummethoxid, Natriumethoxid, Natriumisopropoxid, Kaliummethoxid, Kaliumethoxid, Kaliumisopropoxid, Cäsiummethoxid, Cäsiumethoxid, Cäsiumisopropoxid und Kombinationen davon, ausgewählt ist.

12. Verfahren nach Anspruch 11, wobei der basische Katalysator Natriummethoxid ist und in einer Menge von 0,1 Mol.-% bis 2 Mol.-% vorhanden ist, bezogen auf das Atomgewicht von Natrium und die Molmenge von in dem Polymer vorhandenem Monomer IV.

13. Verfahren nach einem der Ansprüche 1 bis 12, wobei der basische Katalysator in Schritt (b) durch dessen Auflösen in dem alkoholischen Lösungsmittel zugegeben wird.

14. Verfahren nach einem der Ansprüche 1 bis 13, wobei das Ausfällen des Polymers durch Zugeben des Reaktionsmediums zu einem Nicht-Lösungsmittel erreicht wird.

15. Verfahren nach Anspruch 14, wobei das Nicht-Lösungsmittel aus der Gruppe, bestehend aus Wasser, Hexan, Octan, Petrolether und Kombinationen davon, ausgewählt ist.

16. Verfahren nach Anspruch 15, wobei das Nicht-Lösungsmittel Wasser ist.

## Revendications

1. Procédé de préparation d'un copolymère d'un monomère ayant la formule IV, 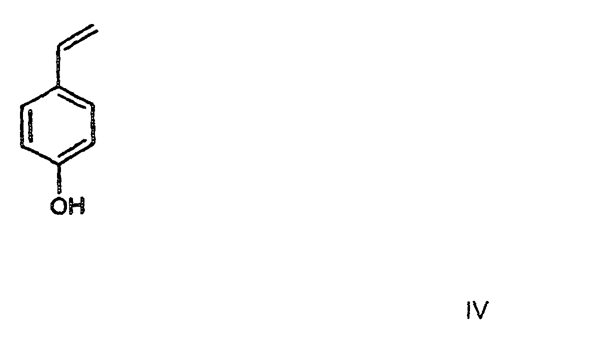 d'un monomère d'acrylate d'alcoyle ayant la formule II, 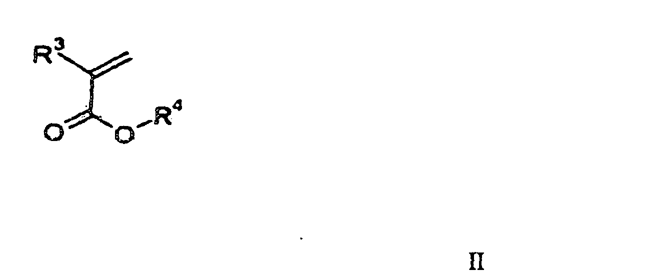 et le cas échéant d'un monomère copolymérisable à insaturation éthylénique choisi dans le groupe consistant en le styrène, en le 4-méthylstyrène, en l'anhydride maléique, en un maléate de dialcoyle, en un fumarate de dialcoyle et en le chlorure de vinyle, alcoyle ayant de 1 à 4 atomes de carbone, comprenant les stades qui consistent :
a) à soumettre un monomère de formule V, 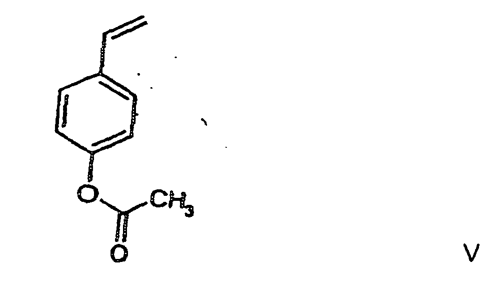 en même temps que le monomère II et le cas échéant, le monomère copolymérisable à des conditions de polymérisation dans un solvant alcoolique et en la présence d'un amorceur à radica libre pour préparer un polymère de composition correspondante ;
b) à soumettre le polymère du stade a) à des conditions de transestérification dans le solvant alcoolique en la présence de quantités catalytiques d'un catalyseur basique en alcoolate de métal alcalin ou en hydroxide de métal alcalin à une température de reflux du solvant alcoolique de façon que l'acétate sous-produit transestérifié formé soit éliminé en continu du mélange de réaction pour former le polymère de IV, de II et, le cas échéant, du monomère copolymérisable ; et
c) à faire passer la solution de polymère dans le solvant alcoolique du stade b) dans un lit d'échange d'ions acide pour éliminer le catalyseur basique; et
d) à isoler le polymère du stade c) par précipitation dans le solvant alcoolique ;dans lequel :
(i) R³ est hydrogène ou méthyle ; et
(ii)R⁴ est isopropyle ou tert-butyle.

2. Procédé suivant la revendication 1, dans lequel on soumet à une polymérisation au stade a), un monomère de formule V, un monomère de formule II et un monomère copolymérisable à insaturation éthylénique, choisi parmi le styrène, le 4- méthylstyrène, l'anhydride maléique, un maléate de dialcoyle, un fumarate de dialcoyle et le chlorure de vinyle, chaque alcoyle ayant de 1 à 4 atomes de carbone.

3. Procédé suivant la revendication 1, dans lequel le copolymère est un copolymère de 4-hydroxystyrène, d'un monomère de formule II et éventuellement de styrène.

4. Procédé suivant la revendication 1, 2 ou 3 dans lequel R³ est hydrogène.

5. Procédé suivant la revendication 1, 2 ou 3, dans lequel R³ est méthyle.

6. Procédé suivant la revendication 1, 2 ou 3 dans lequel le monomère de formule II est l'acrylate de tert-butyle.

7. Procédé suivant l'une quelconque des revendications 1 à 6, dans lequel l'amorceur est choisi dans le groupe consistant en le 2,2'-azobis(2,4-diméthylpentanenitrile), en le 2,2'-azobis(2-méthylpropanenitrile), en le 2,2'-azobis(2-méthylbutanenitrile), en le 1,1'-azobis(cyclohexanecarbonitrile), en le peroxy-2-éthylhexanoate de t-butyle, en le peroxypivalate de t-butyle, en le peroxypivalate de t-amyle, et leurs combinaisons.

8. Procédé suivant l'une des revendications 1 à 7 dans lequel le solvant alcoolique est un alcool ayant de 1 à 4 atomes de carbone choisi dans le groupe consistant en le méthanol, l'éthanol, l'isopropanol, le tert-butanol et leurs combinaisons.

9. Procédé suivant la revendication 8, dans lequel le solvant alcoolique est le méthanol.

10. Procédé suivant l'une quelconque des revendications 1 à 9, dans lequel le catalyseur basique est un alcoolate de métal alcalin.

11. Procédé suivant la revendication 10 dans lequel le catalyseur basique est choisi dans le groupe consistant en le méthylate de litium, en l'éthylate de litium, en l'isopropylate de litium, en le méthylate de sodium, en l'éthylate de sodium, en l'isopropylate de sodium, en le méthylate de potassium, en l'éthylate de potassium, en l'isopropylate de potassium, en le méthylate de césium, en l'éthylate de césium, en l'isopropylate de césium et en leurs combinaisons.

12. Procédé suivant la revendication 11, dans lequel le catalyseur basique est le méthylate de sodium et est présent en une quantité de 0.1 % en mole à 2 % en mole par rapport au poids atomique du sodium et des moles du monomère IV présent dans le polymère.

13. Procédé suivant l'une quelconque des revendications 1 à 12 dans lequel le catalyseur basique est ajouté au stade b) en le dissolvant dans le solvant alcoolique.

14. Procédé suivant l'une quelconque des revendications 1 à 13, dans lequel la précipitation du polymère s'effectue en ajoutant le milieu de réaction à un non-solvant.

15. Procédé suivant la revendication 14, dans lequel le non-solvant est choisi dans le groupe consistant en l'eau, l'hexane, l'octane, l'éther de pétrole et leurs combinaisons.

16. Procédé suivant la revendication 15, dans lequel le non-solvant est l'eau.
